Europäisches Patentamt

(19) European Patent Office

Office européen des brevets

(11) Numéro de publication: **0 193 453 B1**

(12) **FASCICULE DE BREVET EUROPEEN**

(45) Date de publication du fascicule du brevet:
17.05.89

(21) Numéro de dépôt: **86400326.4**

(22) Date de dépôt: **17.02.86**

(51) Int. Cl.⁴: **G01R 23/15, G01R 29/027**

(54) Dispositif pour contrôler la période séparant des impulsions.

(30) Priorité: **21.02.85 FR 8502483**

(43) Date de publication de la demande:
**03.09.86 Bulletin 86/36**

(45) Mention de la délivrance du brevet:
**17.05.89 Bulletin 89/20**

(84) Etats contractants désignés:
**BE DE FR GB IT NL**

(56) Documents cités:
**DE-B- 1 293 839**
**US-A- 3 737 789**
**US-A- 4 403 185**

**PATENTS ABSTRACTS OF JAPAN, vol. 7, no. 38 (P-176)**
**[1183], 16 février 1983, page 77 P 176 & JP - A**
**- 57 190 273**

(73) Titulaire: **JEUMONT-SCHNEIDER Société anonyme dite:,
31-32, Quai de Dion Bouton, F-92811 Puteaux Cedex(FR)**

(72) Inventeur: **Camus, Etienne, 23, Allée des Acacias Avilly
Saint-Léonard, F-60300 Senlis(FR)**

(74) Mandataire: **Weinmiller, Jürgen et al,
Lennéstrasse 9 Postfach 24, D-8133 Feldafing(DE)**

## Description

La présente invention concerne un dispositif pour contrôler la période séparant des impulsions. Un tel dispositif peut notamment être utilisé dans les circuits de voie de chemin de fer, afin de contrôler que les signaux captés dans ces circuits de voie correspondent bien aux signaux émis.

En effet, de nombreuses impulsions parasites aléatoires sont enregistrées dans les rails, notamment à cause des hâcheurs utilisés pour la commande de moteurs de traction, et certaines de ces impulsions parasites présentent une amplitude telle que la partie réceptrice des circuits de voie pourrait les confondre avec les impulsions propres de la partie émettrice du circuit de voie et, par suite, indiquer l'absence de tout train sur le canton considéré alors que précisément il s'y trouve un train.

Il est alors nécessaire de contrôler si l'impulsion entrant dans le circuit est bien l'impulsion émise. Du fait que la période de ces impulsions est bien définie alors que celle des impulsions parasites est aléatoire, on atteint ce but en vérifiant la longueur de la période entre deux impulsions reçues successivement. Compte tenu de l'application envisagée, le contrôle doit naturellement s'effectuer en sécurité (voir les documents US-A 4 403 185 et DE-B 1 293 839).

A cet effet, l'invention propose les dispositifs selon les revendications 1 et 2.

Grâce à ces dispositions, on obtient une impulsion à la sortie du circuit ET, seulement si le nombre prédéterminé mis en mémoire est atteint par le compteur pendant la phase de comptage accéléré. On contrôle ainsi en sécurité la période des impulsions d'entrée sur une fourchette fixe qui, pour une largeur de créneau donnée, dépend essentiellement du rapport entre la fréquence élevée et la fréquence basse.

L'invention sera mieux comprise et d'autres buts, avantages et caractéristiques de celle-ci apparaitront plus clairement à la lecture de la description qui suit, donnée à titre non limitatif, et à laquelle deux planches de dessins sont annexées.

La Figure 1 est un schéma synoptique d'un dispositif de contrôle conforme à l'invention ; et

Les Figures 2A à 2F sont des diagrammes illustrant le fonctionnement de ce dispositif.

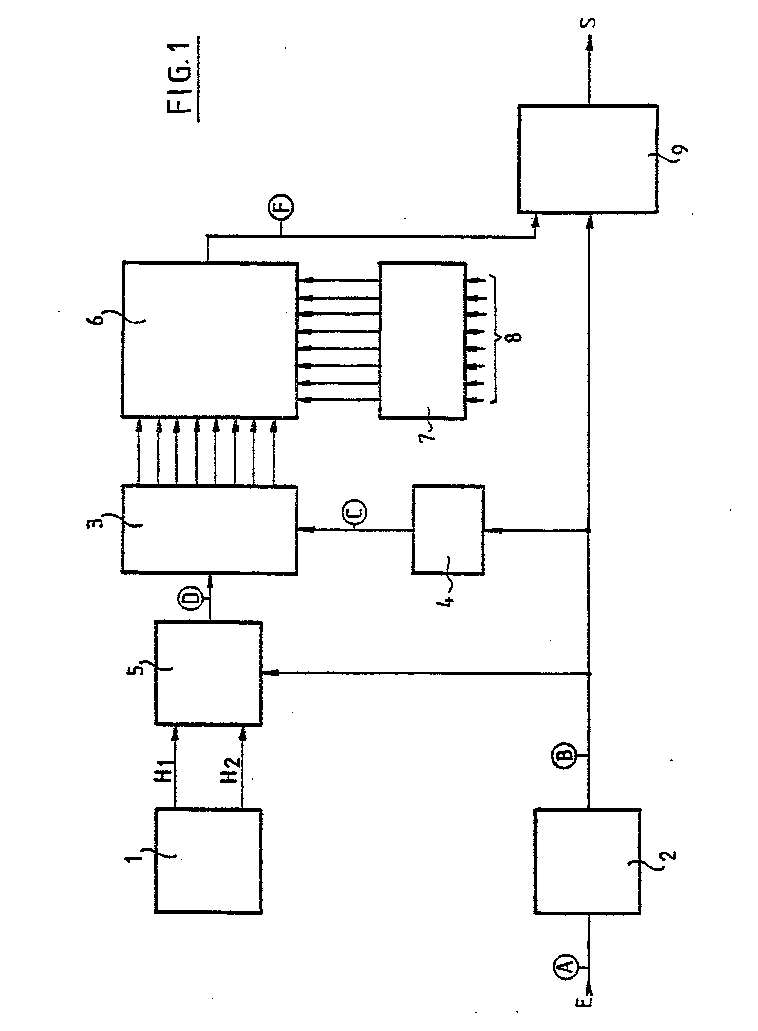

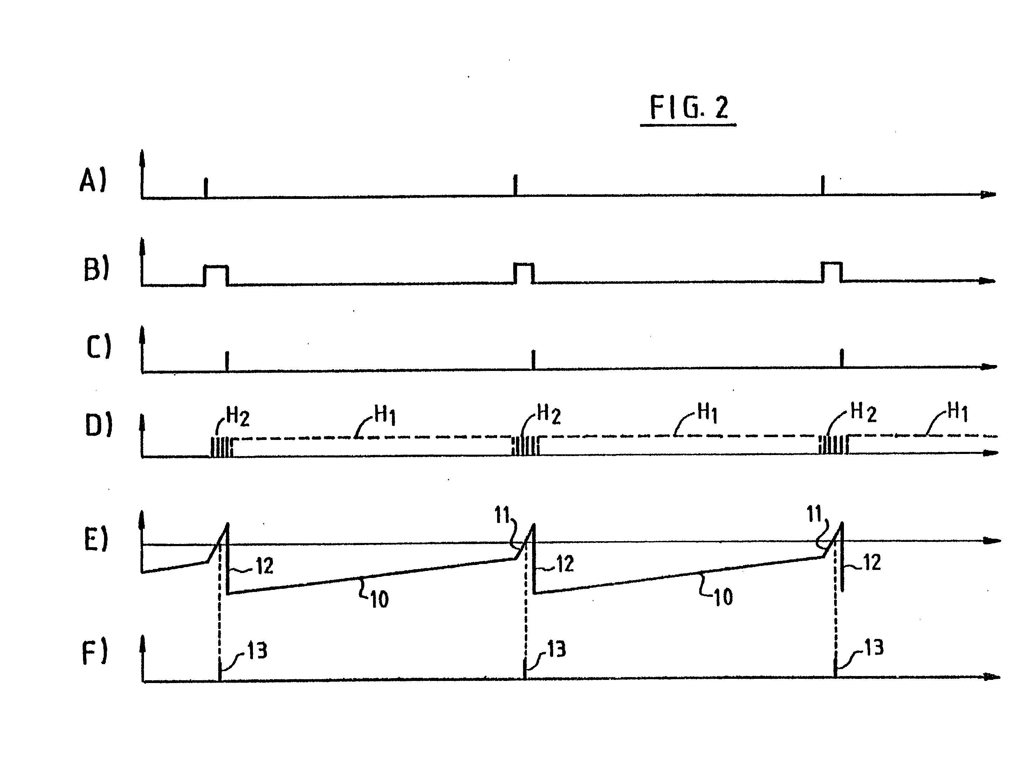

Le dispositif représenté sur la Figure 1 comprend tout d'abord un oscillateur 1 fournissant sur deux sorties un premier signal d'une fréquence basse $H_1$ et un second signal d'une fréquence élevée $H_2$ Ces deux fréquences sont dans un rapport important, par exemple $2^8$. Les impulsions à contrôler sont appliquées sur l'entrée E du dispositif et présentent l'allure représentée sur la Figure 2A.

L'entrée E du dispositif est reliée à une bascule monostable 2 qui, à partir des impulsions d'entrée à contrôler, délivre à sa sortie des créneaux de largeur déterminée dont l'allure est représentée sur la Figure 2B.

L'élément essentiel du dispositif est constitué par un compteur binaire 3, piloté par l'oscillateur 1 et qui délivre ainsi à sa sortie, par exemple sur 8 binons, un nombre binaire dont la valeur est fonction du nombre d'impulsions qui sont appliquées à son entrée.

La remise à zéro de ce compteur est assurée par le front descendant des créneaux issus de la bascule monostable 2, grâce à un circuit 4 délivrant des impulsions dont l'allure est représentée par le diagramme de la Figure 2C.

Entre l'oscillateur 1 et le compteur 3 est disposé un circuit d'aiguillage 5 commandé par ces mêmes créneaux de telle manière que le compteur binaire soit ainsi piloté par le signal de fréquence basse $H_1$ entre les créneaux et par le signal de fréquence élevée $H_2$ pendant la durée desdits créneaux, comme illustré par le diagramme de la figure 2D.

Un comparateur 6, à huit binons, compare à chaque instant le nombre binaire délivré par le compteur 3 à un nombre prédéterminé préalablement enregistré dans une mémoire programmable ou câblée 7, et émet une impulsion à sa sortie lorsque les deux nombres coïncident. Ce nombre prédéterminé correspond à la période à contrôler des impulsions d'entrée et il est inscrit dans la mémoire 7 par des entrées 8.

Le dispositif de contrôle selon l'invention est complété par un circuit ET de coïncidence 9 de type connu, à sécurité intrinsèque, dont les deux entrées sont connectées respectivement à la sortie du monostable 2 et à la sortie du comparateur 6, et dont la sortie constitue la sortie S du dispositif.

On va maintenant décrire le fonctionnement de ce dispositif, en se référant plus particulièrement à la Figure 2E, qui ne représente pas un diagramme réel et a uniquement pour but d'illustrer le mode de comptage du compteur 3.

Après une remise à zéro, le compteur est d'abord piloté par le signal de fréquence basse $H_1$ et effectue donc un comptage lent représenté en 10 sur la Figure 2E. Lorsque l'impulsion suivante arrive, le compteur est piloté par le signal de fréquence élevée $H_2$, par suite de l'actionnement du circuit d'aiguillage 5, et le comptage se trouve donc accéléré pendant toute la durée du créneau correspondant engendré par la bascule monostable 2, comme représenté en 11 sur la Figure 2E. A la fin de ce créneau, le compteur est remis à zéro, comme représenté en 12.

Si le nombre prédéterminé inscrit dans la mémoire 7 est atteint par le compteur 3 pendant la phase de comptage accéléré 11, le comparateur 6 émet une impulsion vers le ET de coïncidence 9, comme représenté en 13 sur le diagramme de la Figure 2F. De plus, comme cette impulsion est émise pendant la durée du créneau correspondant appliqué sur l'autre entrée du circuit ET, on obtient également une impulsion à la sortie S.

On voit par conséquent en définitive qu'avec le dispositif de contrôle selon l'invention, on obtient une impulsion à la sortie S, seulement si le nombre prédéterminé mis en mémoire est atteint par le compteur lors de la phase de comptage accéléré. Ceci permet de contrôler en sécurité la période des impulsions appliquées sur l'entrée E, dans une fourchette fixe en valeur absolue. Bien entendu, le chiffre mis en mémoire devra correspondre à la période la plus longue à contrôler.

A titre d'exemple, si la période à contrôler est d'environ 300ms, on pourra prendre une fréquence $H_1$ correspondant à une période de 833 µs, ce qui donne pour $H_2$ une période de 3,25 µs avec un rapport de 28. Si l'on suppose maintenant que les créneaux délivrés par la bascule monostable 2 ont une durée de 13 µs, il y aura quatre impulsions $H_2$ pendant la phase de comptage accéléré (4 x 3,25 µs =13 µs). La fourchette contrôlée est alors de 4 x 833 µs, soit environ 3,33 ms.

Dans ces conditions, si N est le nombre prédéterminé mis en mémoire et exprimé en décimal, la période la plus longue contrôlée sera égale à N x 833 µs, tandis que la période la plus courte contrôlée sera égale à (N - 4) x 833 µs.

Bien que seul un mode de réalisation ait été décrit, il est évident que toute modification apportée par l'Homme de l'Art dans le même esprit ne sortirait pas du cadre de la présente invention. Par exemple, on utilise de préférence un oscillateur de fréquence très élevée auquel est associé un ou deux diviseurs du type compteur rapide délivrant les impulsions de fréquence basse et celles de fréquence élevée.

De toute évidence, il est utile de recaler régulièrement ces impulsions et l'on peut utilement utiliser l'impulsion reçue en entrée du dispositif pour remettre le ou les compteurs rapides à zéro, le recalage étant dès lors effectué automatiquement lors du traitement de toute nouvelle impulsion reçue.

## Revendications

1 - Dispositif pour contrôler la période séparant des impulsions comprenant une bascule monostable (2) à l'entrée de laquelle sont appliqueés les impulsions à contrôler, le signal de sortie, de la bascule monostable étant appliqué à la première entrée d'un circuit ET de coïncidence (9) dont la sortie constitue la sortie du dispositif caractérisé en ce qu'un oscillateur (1) délivre respectivement sur chacune de ses deux sorties un signal de fréquence basse ($H_1$) et un signal de fréquence élevée ($H_2$) qui sont appliqués aux deux entrées d'un circuit d'aiguillage (5) dont l'entrée de commande est reliée à la sortie de la bascule monostable (2), la sortie du circuit d'aiguillage (5) étant reliée à un compteur binaire (3) dont la borne de remise à zéro est reliée à la sortie d'un circuit (4) délivrant une impulsion en réponse au retour à l'état stable de ladite bascule monostable (2), les signaux de sortie dudit compteur binaire (3) étant appliqués à un comparateur (6) délivrant un signal de sortie lorsque le nombre binaire représentatif des signaux de sortie dudit compteur binaire (3) coïncide avec un nombre binaire prédéterminé, le signal de sortie dudit comparateur (6) étant appliqué à la deuxième entrée du circuit ET de coïncidence (9).

2 - Dispositif pour contrôler la période séparant des impulsions, comprenant une bascule monostable (2) délivrant, à partir des impulsions d'entrée à contrôler, des créneaux de largeur déterminée et un circuit ET de coïncidence (9) dont la première entrée est connectées à la sortie de la bascule monostable (2), la sortie du circuit ET de coïncidence (9) constituant la sortie du dispositif caractérisé en ce qu'il comprend, en combinaison:

- un oscillateur (1) fournissant un signal de fréquence basse ($H_1$) et un signal de fréquence dite élevée ($H_2$) ;
- un compteur binaire (3) dont la remise à zéro est assurée par le front descendant des créneaux ;
- un circuit d'aiguillage (5) commandé par les créneaux issus du circuit monostable (2), de manière que le compteur binaire (3) soit piloté par le signal de fréquence basse ($H_1$) de l'oscillateur (1) entre les créneaux et par le signal de fréquence élevée ($H_2$) pendant la durée desdits créneaux ;
- un comparateur (6) pour comparer le nombre délivré par le compteur (3) à un nombre prédéterminé préalablement enregistré dans une mémoire (7) et correspondant sensiblement à la période à contrôler, ledit comparateur engendrant une impulsion à sa sortie lorsque les deux nombres coïncident, la sortie du comparateur (6) étant reliée à la deuxièmen entrée du circuit ET de coïncidence (9).

## Patentansprüche

1. Anordnung der Überwachung der Zeit-Dauer zwischen Impulsen, mit einer monostabilen Kippstufe (2), an deren Eingang die zu überwachenden Impulse angelegt sind, während das Ausgangssignal der monostabilen Kippstufe an den ersten Eingang eines Koinzidenz-UND-Kreises (9) geschaltet ist, dessen Ausgang den Ausgang der Anordnung bildet, dadurch gekennzeichnet, daß ein Oszillator (1) an einem seiner beiden Ausgänge ein Signal mit niedriger Frequenz ($H_1$) und am anderen Ausgang ein Signal mit hoher Frequenz ($H_2$) abgibt, welche an die beiden Eingänge eines Umschaltkreises (5) angelegt werden, wovon der Steuereingang mit dem Ausgang der monostabilen Kippstufe (2) verbunden ist, während der Ausgang des Umschaltkreises (5) mit einem Binärzähler (3) verbunden ist, dessen Rückstellklemme an den Ausgang eines Kreises (4) geschaltet ist, welcher als Antwort auf die Rückkehr der monostabilen Kippstufe (2) in den stabilen Zustand einen Impuls liefert, wobei die Ausgangssignale des Binärzählers (3) an einen Komparator (6) angelegt sind, der ein Ausgangssignal liefert, wenn die für die Ausgangssignale des Binärzählers (3) repräsentative Binärzahl mit einer vorbestimmten Binärzahl übereinstimmt, und wobei das Ausgangssignal des Komparators (6) an den zweiten Eingang des Koinzidenz-UND-Kreises (9) geschaltet ist.

2. Anordnung zur Überwachung der Zeitdauer zwischen Impulsen, mit einer monostabilen Kippstufe (2), welche ausgehend von den zu überwachenden Eingangsimpulsen Rechteckimpulse bestimmter Dauer liefert, und mit einem Koinzidenz-UND-Kreis (9), dessen erster Eingang mit dem Ausgang der monostabilen Kippstufe (2) verbunden ist, während der Ausgang des Koinzidenz-UND-Kreises (9) den Ausgang der Anordnung bildet, dadurch gekennzeichnet, daß sie in Kombination aufweist:

– einen Oszillator (1), der ein Signal niedriger Frequenz ($H_1$) und ein Signal einer als hoch bezeichneten Frequenz ($H_2$) liefert,
– einen Binärzähler (3), dessen Rückstellung durch die abfallende Flanke der Rechteckimpulse bewirkt wird,

– einen Umschaltkreis (5), der von den vom monostabilen Kreis (2) gelieferten Rechteckimpulsen gesteuert wird, derart, daß der Binärzähler (3) vom Signal niedriger Frequenz (H₁) des Oszillators (1) zwischen den Rechteckimpulsen und vom Signal hoher Frequenz (H₂) während der Dauer der Rechteckimpulse gesteuert wird,

– einen Komparator (6) zum Vergleichen der vom Zähler (3) gelieferten Zahl mit einer vorbestimmten und zuvor in einem Speicher (7) registrierten Zahl, welche im wesentlichen der zu überwachenden Periode entspricht, wobei der Komparator an seinem Ausgang einen Impuls erzeugt, wenn die beiden Zahlen übereinstimmen, und der Ausgang des Komparators (6) mit dem zweiten Eingang des Koinzidenz-UND-Kreises (9) verbunden ist.

**Claims**

1. A device for monitoring the period which separates pulses, comprising a monostable flip-flop (2), to the input of which are applied the pulses to be monitored, the output signal of the monostable being applied to the first input of a coincidence-AND-circuit (9) whose output constitutes the output of the device, characterized in that an oscillator (1) delivers on one of its two outputs a signal of low frequency (H₁) and on the other output a signal of high frequency (H₂), which signals are applied to the two inputs of a switching circuit (5), whose control input is connected to the output of the monostable (2), the output of the switching circuit (5) being connected to a binary counter (3), whose reset to zero terminal is connected to the output of a circuit (4), which is adapted to deliver a pulse in response to the setting of the monostable (2), the output signals of the binary counter (3) being applied to a comparator (6) adapted to deliver an output signal, when the binary number representative of the output signals of said binary counter (3) coincide with a predetermined binary number, the output signal of the comparator (6) being applied to the second input of the coincidence-AND-circuit (9).

2. A device for monitoring the period which separates pulses, comprising a monostable flip-flop (2), adapted to deliver crenelated pulses of a determined length in accordance with the input pulses to be monitored, and a coincidence-AND-circuit (9), whose first input is connected to the output of the monostable (2) and whose output constitutes the output of the device, characterized in that it comprises, in combination:

– an oscillator (1) adapted to deliver a signal of low frequency (H₁) and a signal of a so-called high frequency (H₂),

– a binary counter (3) whose resetting to zero is ensured by using the sloping edge of the crenelated pulses,

– a switching circuit (5) controlled by the crenelated pulses issuing from the monostable (2) in such a way, that the binary counter (3) is driven by the low frequency signal (H₁) of the oscillator during the time period between the crenelated pulses and by the high frequency signal (H₂) throughout the duration of the crenelated pulses,

– a comparator (6) adapted to compare the number supplied by the counter (3) with a predetermined number recorded previously in a memory (7) and corresponding substantially to the period to be monitored, said comparator generating a pulse at its output when the two numbers coincide, the output of the comparator (6) being connected to the second input of the coincidence-AND-circuit (9).

FIG.1

FIG. 2

A)

B)

C)

D)

E)

F)

EP 0 193 453 B1